# EUROPEAN PATENT SPECIFICATION

(11) **EP 1 126 950 B1**
(45) Date of publication and mention of the grant of the patent: **20.11.2002**
(21) Application number: 99911324.4
(22) Date of filing: 12.03.1999
(51) Int. Cl.: B24B 37/04, B24D 13/14, B24B 49/08

(54) **APPARATUSES AND METHODS FOR POLISHING SEMICONDUCTOR WAFERS**
VERFAHREN UND VORRICHTUNG ZUM POLIEREN VON HALBLEITERSCHEIBEN
DISPOSITIFS ET PROCEDES DE POLISSAGE DE TRANCHES DE SEMICONDUCTEUR

(30) Priority: 08.09.1998 US 149166
(43) Date of publication of application: 29.08.2001
(73) Proprietor: ADVANCED MICRO DEVICES INC., Sunnyvale, California 94088-3453 (US)
(72) Inventor: YELLITZ, Bradley, J., Austin, TX 78749 (US); BURKE, Peter, A., Newark, DE 19713 (US)
(74) Representative: Brookes Batchellor
(86) International application number: PCT/US99/05353
(87) International publication number: WO 00/013852

(56) References cited:
- WO-A-99/07518
- US-A- 5 435 772
- US-A- 5 769 699
- US-A- 5 800 248
- US-A- 5 899 745
- PATENT ABSTRACTS OF JAPAN vol. 016, no. 064 (E-1167), 18 February 1992 -& JP 03 259520 A (NEC CORP), 19 November 1991

## Description

### Field of the Invention

The present invention relates generally to apparatuses and methods for fabricating integrated circuit/semiconductor devices. More specifically, the present invention relates to apparatuses and methods for polishing semiconductor wafers.

### Background of the Invention

In the manufacture of integrated circuits, the planarization of semiconductor wafers is becoming increasingly important as the number of layers used to form integrated circuits increases. For instance, metallization layers formed to provide interconnects between various devices may result in nonuniform surfaces. The surface nonuniformities may interfere with the optical resolution of subsequent lithographic steps, leading to difficulty with printing high resolution patterns. The surface nonuniformities may also interfere with step coverage of subsequently deposited metal layers and possibly cause open or shorted circuits.

Various techniques have been developed to planarize the top surface of a semiconductor wafer. One such approach involves polishing the wafer using a polishing slurry that includes abrasive particles mixed in a suspension agent. With this approach, the wafer is mounted in a wafer holder, a polishing pad has its polishing surface coated with the slurry, the pad and the wafer are rotated such that the wafer provides a planetary motion with respect to the pad, and the polishing surface is pressed against an exposed surface of the wafer. The polishing erodes the wafer surface, and the process continues until the wafer is largely flattened. Typically, the slurry is introduced near the center of the pad, forms a ring around the wafer and goes under the wafer as necessary. It is generally desirable to maintain an adequate amount of slurry between the wafer and the pad while dispensing as little slurry as possible to lower costs.

In chemical-mechanical polishing, the slurry particles abrade the wafer surface while a chemical reaction occurs at the wafer surface. For instance, in chemical-mechanical polishing of silicon dioxide, the slurry particles generate high pressure areas that cause the silicon dioxide to react with water. In chemical-mechanical polishing of other materials, such as tungsten, the slurry employs a wet chemical etchant to assist in removing wafer material. The wet chemical etchant is often more selective to the exposed wafer material than to underlying wafer materials.

The polishing pad can be a felt fiber fabric impregnated with polyurethane, with the amount of impregnation determining whether the pad is a "hard pad" or a "soft pad." A hard pad tends to focus the polishing pressure on protruding regions of the wafer surface in order to rapidly planarize the wafer surface. A soft pad tends to create a more even polish over the entire wafer surface, a finer surface finish, and less mechanical damage to the wafer.

A significant goal relating to chemical-mechanical polishing techniques is the maintenance of substantially uniform planarity over the entire surface of a given wafer. Due to problems which will be described in the present application, uniformity is particularly difficult to achieve near the edge of a given wafer.

US-A-5 769 699 discloses a polishing pad comprising a pad structure which has first and second polishing regions, the first polishing region being less compressible that the second polishing region.

The present invention provides a polishing apparatus comprising:
a structure having at least first and second regions to define first and second polishing regions across a polishing surface of the polishing apparatus, the first polishing region being less compressible than the second polishing region, the structure including a recessed portion that corresponds to said second polishing region and a cushioning component at least partially filling said recessed portion , the cushioning component being softer than the part of the structure defining the first polishing region, said recessed portion defined in a side of said structure opposite said polishing surface.

Thus whereas in the above cited prior art the polishing pad is configured so that in the second region the pad is thicker or less compressible compared to the first region, in the present arrangement, there is provided a recess in portion which mounts a cushioning component.

The structure may comprise a pad which includes a polishing component having a first side forming the polishing surface and a second side positioned opposite from the first side, the second side defining the recessed portion that corresponds with the second polishing region such that the polishing component has a greater thickness at the first polishing region as compared to the second polishing region.

Alternatively, said structure may comprise a platen structure adapted for supporting a polishing pad.

### Brief Description of the Drawings

The accompanying. drawings, which are incorporated in and constitute a part of the specification, illustrate several aspects of the invention and together with the description, serve to explain the principles of the invention. A brief description of the drawings is as follows:
FIG. 1 is a schematic plan view of a polishing pad constructed in accordance with the principles of the present invention;
FIG. 2 is a cross-sectional view taken along section line 2-2 of FIG. 1;
FIG. 3 is a schematic cross-sectional view of a polishing system incorporating the polishing pad of FIG. 1;
FIG. 4 is a schematic plan view of a polishing platen constructed in accordance with the principles of the present invention;
FIG. 5 is a cross-sectional view taken along section line 5-5 of FIG. 4;
FIG. 6 is a schematic cross-sectional view of a polishing system incorporating the polishing platen of FIG. 4;
FIG. 7 is a graph illustrating the surface contour of a material polished with a conventional polish pad system; and
FIG. 8 is a graph illustrating the surface contour of a material polished with a system in accordance with the principles of the present invention.

### Detailed Description of the Drawings

Reference will now be made in detail to exemplary aspects of the present invention which are illustrated in the accompanying drawings. Wherever possible, the same reference numbers will be used throughout the drawings to refer to the same or like parts.

Semiconductor devices are commonly fabricated on silicon wafers by introducing sequentially stacked patterned layers, such as conductive, dielectric and capping layers, on the surfaces of the wafers. As the number of these stacked layers increases, planarization techniques are commonly used to optimize the planarity of such layers. Chemical-mechanical polishing (CMP) processes have been developed, and are widely used, to planarize layer surfaces, such as silicon dioxide surfaces, on wafers such as silicon wafers. One of the significant challenges encountered with planarization through the use of CMP processing techniques is to achieve process uniformity near the wafer edge (approximately the outermost .8 ml of the wafer). Using conventional techniques, process uniformity at the outermost edge or portion of a wafer differs greatly from the bulk of the wafer.

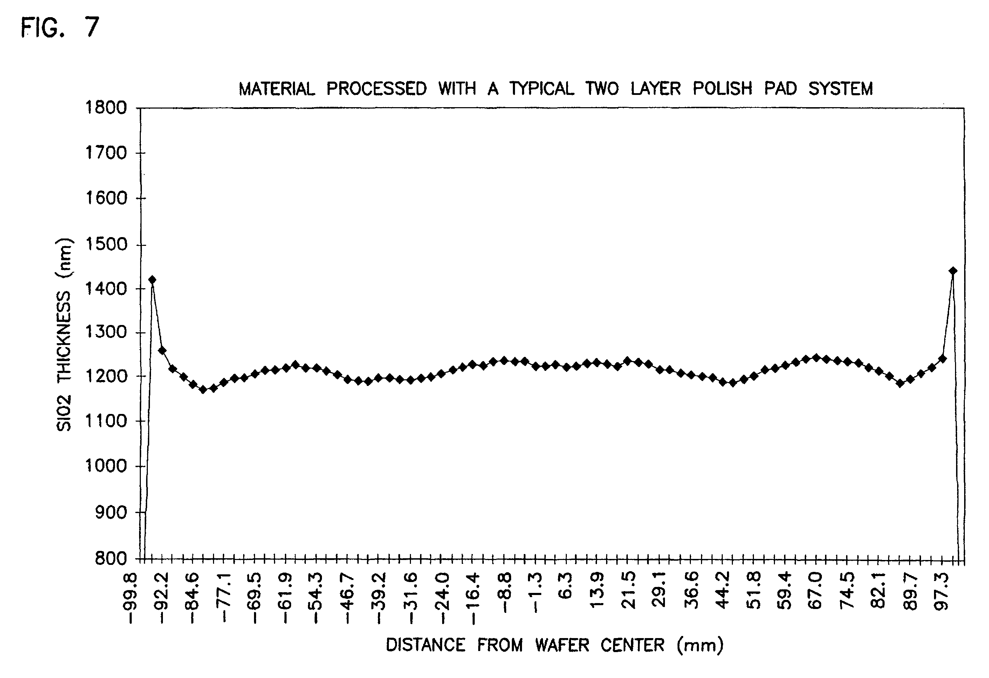

For the removal and planarization of layers, such as silicon dioxide layers, from a wafer surface, a typical polishing system utilizes a polishing pad having a top layer made of a relatively rigid, hard material such as polyurethane, and a bottom layer made of a softer, shock-absorbing material such as felt or foam. This combination provides a mixture of hardness for planarization capability and removal rate, and compressibility for improved process uniformity by dampening system variations. However, the compressibility of the bottom material, which allows for process uniformity across the bulk of the wafer, contributes to the degradation of process uniformity near the wafer edge. Specifically, it has been determined that this occurs because, as the wafer is oscillated across the pad, the pad material compresses as a reaction to polishing forces at the leading edge of the wafer, and then rebounds. This compression and rebound effect is believed to cause non-uniform removal patterns at or near the wafer edge. For example, FIG. 7 illustrates a typical non-uniform removal pattern generated near the edge of a wafer by conventional polish pad systems. The removal pattern of FIG. 7 is just typical, and often the surface nonuniformity generated by conventional polish systems is worse than the pattern specifically shown.

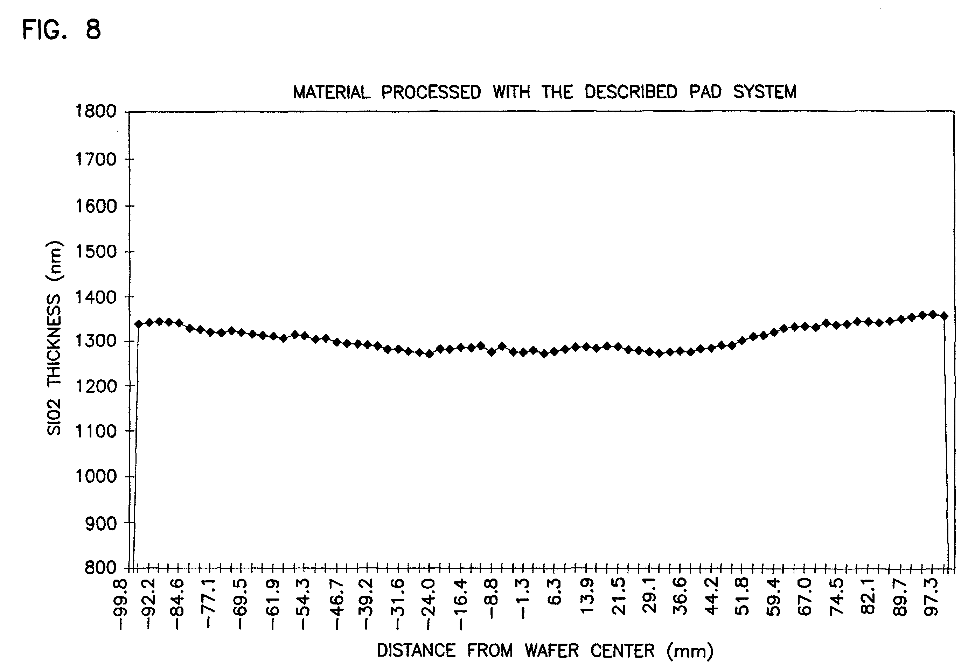

The present invention teaches that uniformity near the wafer edge can be improved or enhanced by varying a polishing surface construction between an area that most affects the surface of a wafer adjacent the wafer edge and that which most affects the bulk surface of the wafer. For example, the compressibility of a polishing surface can be varied through such exemplary techniques as varying the compressibility of particular regions of a polishing pad, or by varying the compressibility of various regions of a polishing platen. In one particular embodiment, an intermediate radial region of a polishing surface can be made more compressible than a remainder of the polishing surface. It has been determined by the inventors that such a construction allows for acceptable process uniformity across the bulk of a wafer, along with improved process uniformity near the edge of the wafer. FIG. 8 shows the improved process uniformity provided by using a polish system in accordance with the principles of the present invention.

The terms "semiconductor wafer" or "wafer" are used throughout this specification and claims. These terms are intended to include wafer substrates as well as wafers having any number of stacked patterned layers. Furthermore, these terms are intended to include all types of semiconductors/integrated circuit devices as well as precursor semiconductors/semiconductor devices.

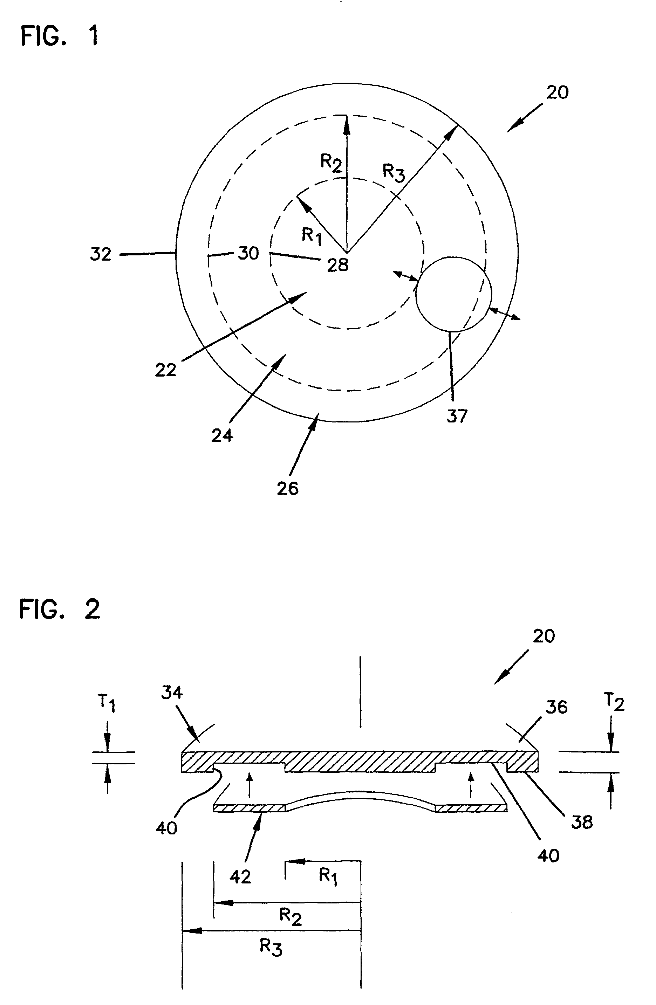

FIGS. 1 and 2 illustrate an exemplary polishing pad 20 constructed in accordance with the principles of the present invention. The exemplary polishing pad 20 includes at least first and second polishing regions having different degrees of compressibility. For example, as shown in FIG. 1, the pad 20 includes an inner polishing region 22, an intermediate polishing region 24, and an outer polishing region 26. In one particular embodiment of the present invention, the intermediate polishing region 24 is more compressible than the inner and outer polishing regions 22 and 26. As shown in FIG. 1, the polishing regions 22, 24 and 26 are generally concentrically aligned relative to one another with the inner polishing region 22 being circular and the intermediate and outer polishing regions 24 and 26 being generally annular. In certain embodiments, the pad can define an inner aperture such that that the inner polishing region is annular. However, it will be appreciated that the invention is not limited to the above-described configurations.

Referring back to FIG. 1, a first boundary 28 forming the outer boundary of the inner polishing region 22 is defined by a first radius R₁. Also, a second boundary 30 forming an outer boundary of the intermediate polishing region 24 is defined by a second radius R₂. Finally, a third boundary 32 coinciding with the outermost edge of the polishing pad 20 and forming an outer boundary of the outer polishing region 26 is defined by a third radius R₃. As is apparent from the above description, the inner polishing region 22 is defined by the first boundary 28, the intermediate polishing region 24 is defined between the first and second boundaries 28 and 30, and the outer polishing region 26 is defined between the second and third boundaries 30 and 32.

For many applications, R₂ is in the range of 1.5 to 5 times as long as R₁, and R₃ is in the range of 2 to 8 times as long as R₁. In one particular embodiment of the present invention, R₁ is about 200 millimeters (mm), R₂ is about 355 mm, and R₃ is about 405 mm.

Referring now to FIG. 2, an exemplary construction configuration for the polishing pad 20 is illustrated. As shown in FIG. 2, the polishing pad 20 includes a polishing component 34 having a top side 36 forming a polishing surface adapted for polishing a semiconductor wafer 37, and a bottom side 38 adapted to face a polishing platen. The bottom side 38 defines a recess 40 that coincides or corresponds generally with the intermediate polishing region 24. A cushioning component 42 is disposed within and at least partially fills the recess 40. As shown in FIG. 2, the recess 40 and the cushioning component 42 are both annular. However, it will be appreciated that the present invention is not limited to such a configuration.

Because the polishing component 34 is recessed adjacent the intermediate polishing region 24, the polishing component 34 has a greater thickness at the inner and outer polishing regions 22 and 26 as compared to the intermediate polishing region 24. For many applications, the polishing component 34 has a thickness T₁ at the intermediate polishing region 24 that is about half as thick as the thickness T₂ of the polishing component 34 at the inner and outer polishing regions 22 and 26. In one particular embodiment of the present invention, T₁ is about .64 mm (.025 inch) while T₂ is about 1.27 mm (.05 inch). It will be appreciated that the above described ratios and ranges are strictly exemplary and are not intended to be a limitation upon the present invention.

For many applications, the polishing component 34 of the polishing pad 20 is made of a relatively hard, rigid and non-compressible material, while the cushioning component 42 of the pad 20 is made of a relatively soft, resilient, and compressible material. In one particular embodiment, the polishing component is made of a material such as polyurethane or a polyurethane-impregnated polyester felt. Additionally, in one embodiment of the present invention, the cushioning component 42 is made of a material such as felt or foam. In certain embodiments of the present invention, the material used to make the cushioning component is in the range of 5 - 15 times more compressible than the material used to make the polishing component. Preferably, the material of the cushioning component is about 10 times more compressible than the material of the polishing component. An exemplary polishing component has a Shore D hardness of 60 while a cushioning component has a Shore A hardness of 65.

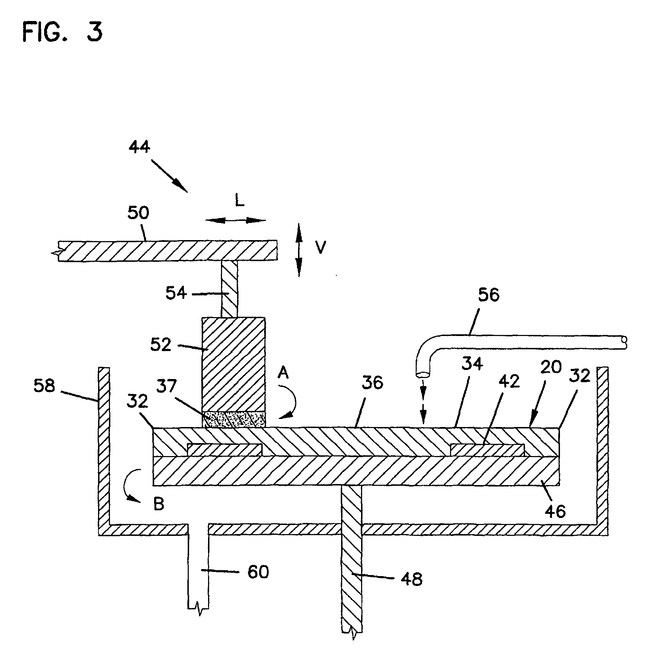

FIG. 3 shows a cross-sectional view of a polishing system 44 incorporating the polishing pad 20 described above. The polishing system 44 includes a rotatable platen 46 to which the polishing pad 20 is secured. The platen 46 is rotated about its central axis via a drive spindle 48. The polishing system 44 also includes a polishing arm 50 that is adapted to move both laterally (direction L) and vertically (direction V). The polishing arm 50 includes a wafer holder 52 for removably securing the wafer 37 by such means as a vacuum suction. The wafer holder 52 is rotated by a chuck spindle 54. The polishing system 44 further includes a fluid dispenser 56 for dispensing a fluid onto the polishing pad 20, and a sink 58 for containing materials that are propelled off the polishing pad 20.

An exemplary operation of the system 44 will now be described. Initially, the chuck spindle 54 rotates the wafer holder 52 and the wafer 37 in a clockwise direction A, the drive spindle 48 rotates the platen 46 and the pad 20 in a counterclockwise direction B, the polishing arm 50 holds the wafer 37 above the polishing pad 20, and the dispenser 56 dispenses a polishing slurry onto the polishing surface 36 of the polishing pad 20. After contacting the pad 20, the slurry flows centrifugally toward the outermost boundary 32 of the pad 20 and is slung off the pad 20. Thereafter, the polishing arm 50 is actuated downward so that the wafer 37 is pressed against the top side 36 of the polishing pad 20. The polishing arm 50 continues to exert a downward pressure to enable the pad 20 and the slurry to erode and polish the wafer 37. Concurrently, the polishing arm 50 radially oscillates the wafer across the inner polishing region 22, the intermediate polishing region 24, and outer polishing region 26. For example, the wafer 37 can be oscillated between outer boundary 32 of the pad 20 and the center of the pad 20.

As the wafer 37 is polished, excess slurry and removed materials exit the sink 58 through drain 60. After the polished surface of the wafer is sufficiently smooth, the dispenser 56 dispenses cleaning fluid instead of slurry while the polishing arm 50 continues to exert downward pressure on the wafer 37. As a result, the cleaning fluid flushes slurry and other contaminants on the wafer 37 and pad 20 down the drain 60. After the cleaning is finished, the polishing arm 50 is retracted from the platen 46 and the wafer 37 is removed from the wafer holder 52. Subsequently, another wafer can be placed on the wafer holder 52 and the above-described process can be repeated.

During the above exemplary CMP process, the wafer 37 is oscillated such that an outer edge portion of the wafer 37 spends a majority of the polishing time in contact with the inner and outer polishing regions 22 and 26, while the main body of the wafer 37 spends a majority of the polishing time in contact with the intermediate polishing region 24. The cushioned intermediate polishing region 24 is adapted to exhibit sufficient compressibility to achieve uniformity across the bulk of the wafer surface. Additionally, the reduced compressibility at the inner and outer polishing regions 22 and 26 functions to inhibit the degradation of process uniformity near the wafer edge. As a result, acceptable process uniformity across the entire wafer, including the region proximate the wafer edge, can be achieved.

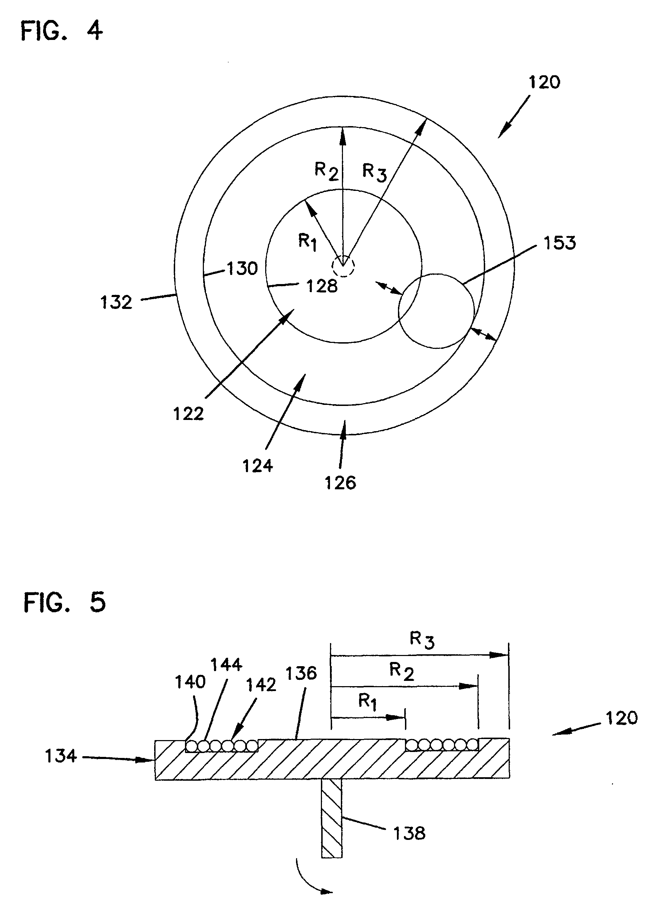

FIGS. 4 and 5 illustrate an exemplary polishing platen 120 constructed in accordance with the principles of the present invention. The exemplary platen 120 includes at least first and second regions having different degrees of compressibility. For example, as shown in FIG 4, the platen 120 includes an inner polishing region 122, an intermediate polishing region 124, and an outer polishing region 126. In one particular embodiment of the present invention, the intermediate polishing region 124 is more compressible than the inner and outer polishing regions 122 and 126. As shown in FIG 4, the polishing regions 122, 124, and 126 are generally concentrically aligned relative to one another with the inner polishing region 122 being circular and the intermediate and outer polishing regions 124 and 126 being generally annular. However, it will be appreciated that the present invention is not limited to such a specific configuration.

Referring again to FIG 4, a first boundary 128 forming the outer boundary of the inner polishing region 122 is defined by a first radius R₁. Also, a second boundary 130 forming an outer boundary of the intermediate polishing region 124 is defined by a second radius R₂. Finally, a third boundary 132 coinciding with the outermost edge of the platen 120 and forming an outer boundary of the outer polishing region 126 is defined by a third radius R₃. As can be inferred from the above description, the inner polishing region 122 is defined by the first boundary 128, the intermediate polishing region, 124 is defined between the first and second boundaries 128 and 130, and the outer polishing region 126 is defined between the second and third boundaries 130 and 132. For many applications, the dimensions of R₁, R₂, and R₃ are the same as those previously specified with respect to the polishing pad 20 of FIGS. 1 and 2.

Referring now to FIG 5, an exemplary construction configuration for the polishing platen 120 is illustrated. As shown in FIG 5, the polishing platen 120 includes a polishing deck or plate 134 having a top side 136 adapted for supporting a polishing pad. The bottom of the polishing plate 134 is shown coupled to a drive mechanism such as a drive spindle 138 adapted for rotating the polishing plate 134 about its central axis. The top side 136 of the polishing plate 134 defines a recess 140 that coincides or corresponds generally with the intermediate polishing region 124. In one particular embodiment of the present invention, the recess 140 has a depth of about 100 mm. A cushioning component 142 is disposed within and at least partially fills the recess 140. As shown in FIG 5, the recess 140 and the cushioning component 142 both have a generally annular configuration. However, it will be appreciated that the present invention is not limited to such a configuration.

For many applications, the polishing platen plate 134 is made of a relatively hard, rigid and non-compressible material such as carbon steel. By contrast, for many applications, the cushioning structure 142 is made of a relatively soft, flexible and compressible material such as shock absorbent foam, felt or a media filled bladder. In the particular embodiment illustrated in FIG 5, the cushioning structure 142 is shown as a plurality of tubular bladders 144 that extend around the recess 140 and are at least partially filled with fluid. Although the bladders 144 are shown as tubular members, it will be appreciated that the present invention also includes other bladder configurations such as a single annular bladder, or multiple radially spaced bladders. Furthermore, spokes, ties or reinforcing members can be disposed between, around, along or within the bladders to control or limit the amount the bladders deform when compressive forces are applied to portions of the bladders. For example, the spokes, ties or reinforcing members can be arranged to inhibit a first portion of a given bladder from over-expanding when a compressive force is applied to a second portion of such bladder.

The above-described bladders can be filled with any number of different types of fluids. For example, the bladders can be filled with gasses such as ambient air or nitrogen. Alternatively, the bladders can be filled with liquid such as water. When used as a cushioning structure, the bladders function to absorb platen imperfections and dampen process variations. Specifically, the cushioning structures 142, that may include bladders or other resilient material, allow portions of a polish pad mounted on the platen 120 to flex, bend or compress during CMP operations.

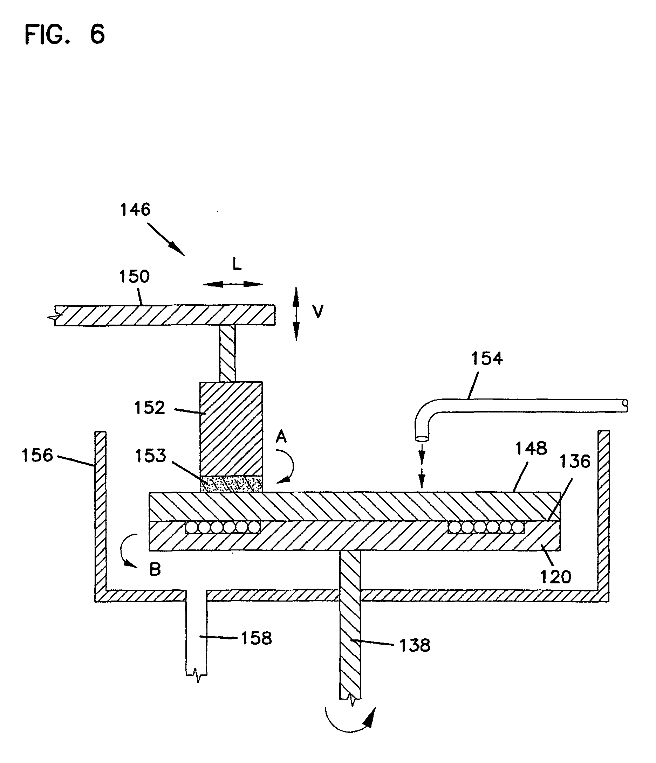

FIG 6 shows a cross-sectional view of a polishing system 146 incorporating the polishing platen 120. The system 146 includes a polishing pad 148 supported on the top side 136 of the polishing platen 120. In one particular embodiment, the pad has a substantially constant thickness and is made of a relatively hard non-compressible material such as polyurethane without any cushioning layer. However, it will be appreciated that the present invention is not limited to such pads and includes other type of pad configurations including, for example, conventional pads as well as pads similar to the polishing pad 20 depicted in FIGS. 1 and 2. Additionally, pads with central openings can also be used.

The system 146 also includes a polishing arm 150 including a wafer holder 152 such as a chuck. A wafer 153 is shown with its back side (opposite the side to be polished) removably secured to the wafer holder 152 by convention means such as vacuum suction. The polishing arm 150 is movable both laterally (direction L) and vertically (direction V). The system also includes a fluid dispenser 154 for dispensing a fluid onto the pad 148, and a sink 156 for containing materials propelled from the pad 148. The sink 156 is in fluid communication with a drain 158 for draining materials that collect in the sink 156.

The system 146 operates in a similar manner to the polishing system 44 previously described with respect to FIG 3. In an exemplary operating sequence, the polishing platen 120 is rotated by the drive spindle 138, and the wafer 153 is rotated by the wafer holder 152. Concurrently, a polishing fluid such as a polishing slurry is applied to the pad 148 from the fluid dispenser 154. Next, the wafer 153 is pressed down against the pad 148 by the polish arm 150, and the wafer 153 is radially oscillated across the polishing pad 148. For example, the wafer 153 can be oscillated between the center and the outer boundary of the polish pad 148.

As the wafer 153 is oscillated, the underlying polishing pad 148 is pressed against the top side 136 of the polishing platen 120. At the non-recessed portions of the polish platen 120, the pad 148 is firmly supported by the inner and outer regions 122 and 126 of the polishing platen 120. Consequently, as the pad is oscillated, minimal compression of the pad 148 occurs over the inner and outer 122 and 126 regions. In contrast, when the wafer 153 is oscillated across the intermediate region 124, the cushioning structure 142 of the polishing platen 120 allows the portion of the pad 148 corresponding to such intermediate region 124 to flex or compress such that system variations are dampened and acceptable process uniformity is achieved.

While the wafer 153 is polished, excess slurry and removed materials exit the sink 156 through the drain 158. After the polished surface of the wafer is sufficiently smooth, the dispenser 154 dispenses cleaning fluid instead of slurry while the polishing arm 150 continues to exert downward pressure on the wafer 153. As a result, the cleaning fluid flushes slurry and other contaminants on the wafer and pad 148 down the drain 158. After the cleaning is finished, the polishing arm 150 is retracted from the platen 120 and the wafer 153 is removed from the wafer holder 152. Subsequently, another wafer can be placed on the wafer holder 152 and the above-described process can be repeated.

During the above exemplary CMP process, the wafer 153 is oscillated such that an outer edge portion of the wafer 153 spends a majority of the polishing time in contact with the portion of the pad 148 that corresponds to the inner and outer regions 122 and 126, while the main body of the wafer 153 spends a majority of the polishing time in contact with the portion of the pad 148 that corresponds to the intermediate polishing region 124. The combination of compressible and non-compressible regions, as provided by the inner, intermediate and outer regions 122, 124 and 126 of the platen 120, allows for acceptable process uniformity across the bulk of the wafer 153, along with improved process uniformity near the wafer edge.

With regard to the foregoing description, it is to be understood that changes may be made in detail, especially in matters of the construction materials employed and the size, shape and arrangement of the parts without departing form the scope of the present invention. For example, a given platen or pad can be divided into more or less than three regions without departing from the scope of the present invention. Additionally, although the platens illustrated in the present application relate to rotatable platens, it will be appreciated that the principles of the present invention also apply to other platen designs such as linear oscillating platens. Furthermore, platens and pads in accordance with the principles of the present invention can be used with single head or multi-head polishing devices. It is intended that the specification and depicted aspects of the invention be considered exemplary only with a true scope and spirit of the invention being indicated by the broad meaning of the following claims.

## Claims

1. A polishing apparatus comprising:
a structure (20,120) having at least first (22) and second (24) regions to define first and second polishing regions across a polishing surface (36) of the polishing apparatus, the first polishing region being less compressible than the second polishing region, the structure including a recessed portion (40, 140) that corresponds to said second polishing region and a cushioning component at least partially filling said recessed portion, the cushioning component (42, 142) being softer than the part of the structure defining the first polishing region, said recessed portion (40, 140) defined in a side of said structure opposite said polishing surface.

2. The polishing apparatus of claim 1, wherein the structure comprises a pad which includes a polishing component having a first side (20) forming the polishing surface and a second side (38) positioned opposite from the first side, the second side defining the recessed portion that corresponds with the second polishing region such that the polishing component has a greater thickness at the first polishing region as compared to the second polishing region.

3. The polishing apparatus of claim 2, wherein the polishing component is made of a polyurethane material.

4. The polishing apparatus of any of claims 1 to 3, wherein the cushioning component is made of a foam material.

5. The polishing apparatus of any of claims 1 to 3, wherein the cushioning component is made of a felt material.

6. The polishing apparatus of any of claims 1 to 5, further comprising a third polishing region (26) that is less compressible than the second polishing region.

7. The polishing apparatus of claim 6, wherein the first polishing region is an inner polishing region, the second polishing region is an intermediate polishing region, and the third polishing region (26) is an outer polishing region.

8. The polishing apparatus of claim 7, wherein the inner polishing region is generally circular and the intermediate and outer polishing regions are generally annular, and wherein the central polishing region, the intermediate polishing region, and the outer polishing region are concentric with respect to one another.

9. The polishing apparatus of claim 7, wherein the pad structure includes a polishing component forming the polishing surface, the polishing component defining a recessed portion that corresponds with the second polishing region, the recessed portionbeing at least partially filled with a cushioning component that is softer than the polishing component.

10. The polishing apparatus of claim 1 in which said structure comprises a platen structure (120) adapted for supporting a polishing pad (148).

11. The polishing apparatus of claim 10, wherein the platen structure includes a platen plate including a recessed portion (140) that corresponds with the second region.

12. The polishing apparatus of claim 1, wherein the cushioning component comprises at least one bladder at least partially filled with fluid.

13. The polishing apparatus of claim 12, wherein the fluid is a liquid.

14. The polishing apparatus of claim 12, wherein the fluid is a gas.

15. The polishing apparatus of claims 10 or 11, wherein the platen structure includes first, second and third regions adapted for supporting a polishing pad, the first and third regions being less compressible than the second region.

16. The polishing apparatus of claim 15, wherein the first region is an inner radial region, the second region is an intermediate radial region, and the third region is an outer radial region.

17. The polishing apparatus of claim 16, wherein the inner radial region is generally circular and the intermediate and outer radial regions are generally annular.

18. The polishing apparatus of claim 17, wherein the platen structure includes a platen plate including a recessed portion that corresponds with the intermediate radial region, and the platen structure further comprises a cushioning structure that at least partially fills the recessed portion, the cushioning structure being more compressible than the platen plate.

19. The polishing apparatus of claim 10 further comprising:
a drive mechanism (138) for rotating the polishing platen;
a polishing pad mounted on the polishing platen; and
a source (154) of polishing fluid adapted for providing polishing fluid to the polishing pad.

## Patentansprüche

1. Poliervorrichtung mit:
einer Struktur (20,120) mit mindestens ersten (22) und zweiten (24) Regionen, die erste und zweite Polierregionen auf einer Polierfläche (36) der Poliervorrichtung bilden, wobei die erste Polierregion weniger kompressibel ist als die zweite Polierregion, die Struktur einen Ausnehmungsbereich (40,140) aufweist, der der zweiten Polierregion entspricht, und eine Polsterkomponente mindestens teilweise den Ausnehmungsbereich ausfüllt, die Polsterkomponente (42,142) weicher ist als derjenige Teil der Struktur, der die erste Polierregion bildet, und der Ausnehmungsbereich (40,140) in einer Seite der Struktur gegenüber der Polierfläche ausgebildet ist.

2. Poliervorrichtung nach Anspruch 1, bei der die Struktur ein Pad aufweist, das mit einer ersten Polierkomponente mit einer ersten Seite (20), die die Polierfläche bildet, und einer zweiten Seite (38), die gegenüber der ersten Seite angeordnet ist, versehen ist, wobei die zweite Seite den Ausnehmungsbereich bildet, der der zweiten Polierregion entspricht, so dass die Polierkomponente in der ersten Polierregion eine größere Dicke als in der zweiten Polierregion aufweist.

3. Poliervorrichtung nach Anspruch 2, bei der die Polierkomponente aus einem Polyurethanmaterial gefertigt ist.

4. Poliervorrichtung nach einem der Ansprüche 1 bis 3, bei der die Polsterkomponente aus einem Schaummaterial gefertigt ist.

5. Poliervorrichtung nach einem der Ansprüche 1 bis 3, bei der die Polsterkomponente aus einem Filzmaterial gefertigt ist.

6. Poliervorrichtung nach einem der Ansprüche 1 bis 5, ferner mit einer dritten Polierregion (26), die weniger kompressibel ist als die zweite Polierregion.

7. Poliervorrichtung nach Anspruch 6, bei der die erste Polierregion eine innere Polierregion ist, die zweite Polierregion eine Zwischen-Polierregion ist und die dritte Polierregion (26) eine äußere Polierregion ist.

8. Poliervorrichtung nach Anspruch 7, bei der die innere Polierregion im wesentlichen kreisförmig ausgebildet ist und die Zwischen-Polierregion und die äußere Polierregion im wesentlichen ringförmig ausgebildet sind und bei der die zentrale Polierregion, die Zwischen-Polierregion und die äußere Polierregion konzentrisch zueinander verlaufen.

9. Poliervorrichtung nach Anspruch 7, bei der die Padstruktur eine Polierkomponente aufweist, die die Polierfläche bildet, wobei die Polierkomponente einen Ausnehmungsbereich aufweist, der der zweiten Polierregion entspricht und der Ausnehmungsbereich mindestens teilweise von einer Polsterkomponente ausgefüllt ist, die weicher ist als die Polierkomponente.

10. Poliervorrichtung nach Anspruch 1, bei der die Struktur eine Plattenstruktur (120) zum Halten eines Polierpads (148) aufweist.

11. Poliervorrichtung nach Anspruch 10, bei der die Plattenstruktur eine Platte mit einem Ausnehmungsbereich (140) aufweist, der der zweiten Region entspricht.

12. Poliervorrichtung nach Anspruch 1, bei der die Polsterkomponente mindestens eine mindestens teilweise mit einem Fluid gefüllte Blase aufweist.

13. Poliervorrichtung nach Anspruch 12, bei der das Fluid eine Flüssigkeit ist.

14. Poliervorrichtung nach Anspruch 12, bei der das Fluid ein Gas ist.

15. Poliervorrichtung nach Anspruch 10 oder 11, bei der die Plattenstruktur erste, zweite und dritte Bereiche zum Halten eines Polierpads aufweist, wobei die ersten und dritten Regionen weniger kompressibel sind als die zweite Region.

16. Poliervorrichtung nach Anspruch 15, bei der die erste Region eine radiale innere Region, die zweite Region eine radiale Zwischenregion und die dritte Region eine radiale äußere Region ist.

17. Poliervorrichtung nach Anspruch 16, bei der die radiale innere Region im wesentlichen kreisförmig ausgebildet ist und die radiale Zwischenregion und die radiale äußere Region im wesentlichen ringförmig ausgebildet sind.

18. Poliervorrichtung nach Anspruch 17, bei der die Plattenstruktur eine Platte mit einem Ausnehmungsbereich aufweist, der der radialen Zwischenregion entspricht, und die Plattenstruktur ferner eine Polsterstruktur aufweist, die den Ausnehmungsbereich mindestens teilweise ausfüllt, wobei die Polsterstruktur stärker kompressibel ist als die Platte.

19. Poliervorrichtung nach Anspruch 10, ferner mit:
einem Antriebsmechanismus (138) zum Drehen der Polierplatte;
einem auf der Polierplatte montierten Polierpad; und
einer Quelle (154) für Polierfluid zum Versorgen des Polierpads mit Polierfluid.

## Revendications

1. Appareil de polissage comprenant :
une structure (20, 120) possédant au moins une première (22) et une deuxième régions (24) pour définir une première et une deuxième régions de polissage à travers une surface de polissage (36) de l'appareil de polissage, la première région de polissage étant moins compressible que la deuxième région de polissage, la structure comprenant une partie encastrée (40, 140) qui correspond à ladite deuxième région de polissage et un composant amortisseur remplissant au moins partiellement ladite partie encastrée, le composant amortisseur (42, 142) étant plus doux que la partie de la structure définissant la première région de polissage, ladite partie encastrée (40, 140) définie dans un côté de ladite structure opposé à ladite surface de polissage.

2. Appareil de polissage selon la revendication 1, dans lequel la structure comprend un tampon qui comprend un composant de polissage possédant un premier côté (20) formant la surface de polissage et un deuxième côté (38) positionné à l'opposé du premier côté, le deuxième côté définissant la partie encastrée qui correspond à la deuxième région de polissage de manière à ce que le composant de polissage ait une épaisseur supérieure au niveau de la première région de polissage comparativement à la deuxième région de polissage.

3. Appareil de polissage selon la revendication 2, dans lequel le composant de polissage est composé d'un matériau en polyuréthane.

4. Appareil de polissage selon l'une quelconque des revendications 1 à 3, dans lequel le composant amortisseur est composé d'un matériau en mousse.

5. Appareil de polissage selon l'une quelconque des revendications 1 à 3, dans lequel le composant amortisseur est composé d'un matériau en feutre.

6. Appareil selon l'une quelconque des revendications 1 à 5, comprenant en outre une troisième région de polissage (26) qui est moins compressible que la deuxième région de polissage.

7. Appareil de polissage selon la revendication 6, dans lequel la première région de polissage est une région de polissage intérieure, la deuxième région de polissage est une région de polissage intermédiaire et la troisième région de polissage (26) est une région de polissage extérieure.

8. Appareil de polissage selon la revendication 7, dans lequel la région de polissage intérieure est généralement circulaire et les régions intermédiaires et extérieures sont généralement annulaires et dans lequel la région de polissage centrale, la région de polissage intermédiaire et la région de polissage extérieure sont concentriques les unes par rapport aux autres.

9. Appareil de polissage selon la revendication 7, dans lequel la structure de tampon comprend un composant de polissage formant la surface de polissage, le composant de polissage définissant une partie encastrée qui correspond à la deuxième région de polissage, la partie encastrée étant au moins partiellement remplie d'un composant amortisseur qui est plus doux que le composant de polissage.

10. Appareil de polissage selon la revendication 1, dans lequel ladite structure comprend une structure cylindrique (120) adaptée pour supporter un tampon de polissage (148).

11. Appareil de polissage selon la revendication 10, dans lequel la structure cylindrique comprend une plaque cylindrique comprenant une partie encastrée (140) qui correspond à la deuxième région.

12. Appareil de polissage selon la revendication 1, dans lequel le composant amortisseur comprend au moins une vessie au moins partiellement remplie de fluide.

13. Appareil de polissage selon la revendication 12, dans lequel le fluide est un liquide.

14. Appareil de polissage selon la revendication 12, dans lequel le fluide est un gaz.

15. Appareil de polissage selon la revendication 10 ou 11, dans lequel la structure cylindrique comprend une première, une deuxième et une troisième régions adaptées pour supporter un tampon de polissage, la première et la troisième régions étant moins compressibles que la deuxième région.

16. Appareil de polissage selon la revendication 15, dans lequel la première région est une région radiale intérieure, la deuxième région une région radiale intermédiaire et la troisième région une région radiale extérieure.

17. Appareil de polissage selon la revendication 16, dans lequel la région radiale intérieure est généralement circulaire et les régions intermédiaire et extérieure sont généralement annulaires.

18. Appareil de polissage selon la revendication 17, dans lequel la structure cylindrique comprend une plaque cylindrique comprenant une partie encastrée qui correspond à la région radiale intermédiaire, et la structure cylindrique comprend en outre une structure d'amortisseur qui remplit au moins partiellement la partie encastrée, la structure d'amortisseur étant plus compressible que la plaque cylindrique.

19. Appareil de polissage selon la revendication 10, comprenant en outre :
un mécanisme d'entraînement (138) destiné à faire pivoter le cylindre de polissage ;
un tampon de polissage monté sur le cylindre de polissage ; et
une source (154) de fluide de polissage adaptée pour proposer un fluide de polissage au tampon de polissage.
